# EUROPEAN PATENT APPLICATION

(11) **EP 4 791 171 A1**
(43) Date of publication of application: **12.08.2026**
(21) Application number: 24876604.0
(22) Date of filing: 10.10.2024
(51) Int. Cl.: H10N 30/80, H10N 30/853, H10N 30/01

(54) **PIEZOELECTRIC ELEMENT AND MANUFACTURING METHOD THEREFOR, PIEZOELECTRIC DEVICE, AND ELECTRONIC DEVICE**

(30) Priority: 13.10.2023 CN 202311342306
(71) Applicant: HUAWEI TECHNOLOGIES CO., LTD., Shenzhen 518129 (CN)
(72) Inventor: YOSUKE, Nakano, Shenzhen, Guangdong 518129 (CN); LU, Xiaoyu, Shenzhen, Guangdong 518129 (CN); MITSUHIRO, Yoda, Shenzhen, Guangdong 518129 (CN); ZHANG, Qiang, Shenzhen, Guangdong 518129 (CN); YANG, Tianyue, Shenzhen, Guangdong 518129 (CN); YANG, Zhifeng, Shenzhen, Guangdong 518129 (CN)
(74) Representative: Thun, Clemens
(86) International application number: PCT/CN2024/124003
(87) International publication number: WO 2025/077792

(57) **Abstract**

Embodiments of this application provide a piezoelectric element and a preparation method therefor, a piezoelectric device, and an electronic device, and relate to the field of semiconductor device technologies, to reduce a manufacturing error of the piezoelectric element and improve uniformity of piezoelectric elements. The piezoelectric element includes a substrate, a vibration plate, and a plurality of piezoelectric elements. The substrate has a plurality of cavities that penetrate the substrate along a thickness direction, the plurality of cavities are sequentially arranged along a first direction of the substrate, and the substrate is a monocrystalline silicon substrate. The vibration plate covers the substrate and the plurality of cavities. A value of the first direction deviates within a range of ±15° of a <100> crystal orientation of the substrate. In the foregoing range, a value of E/(1-v²) of the vibration plate is small, and the value of E/(1-v²) of the vibration plate is the smallest in the <100> direction of the substrate. Therefore, after the plurality of cavities are arranged along the first direction, impact of a film thickness deviation, a film quality deviation, and a mechanical performance deviation of the vibration plate on uniformity of the piezoelectric elements is reduced.

## Description

This application claims priority to Chinese Patent Application No. 202311342306.0, filed with the China National Intellectual Property Administration on October 13, 2023 and entitled "PIEZOELECTRIC ELEMENT AND PREPARATION METHOD THEREFOR, PIEZOELECTRIC DEVICE, AND ELECTRONIC DEVICE", which is incorporated herein by reference in its entirety.

### TECHNICAL FIELD

This application relates to the field of semiconductor device technologies, and in particular, to a piezoelectric element and a preparation method therefor, a piezoelectric device, and an electronic device.

### BACKGROUND

In recent years, with development of the semiconductor industry, micro-electro mechanical systems (micro-electro mechanical systems, MEMS) piezoelectric devices based on piezoelectric elements have been proposed. Due to features such as a small size, a light weight, low power consumption, good durability, low prices, and stable performance, the MEMS piezoelectric devices are widely used in various fields such as industry, biology, and medical care. In addition, miniaturized MEMS piezoelectric devices driven at a low voltage and a high speed have become mainstream trend products in the future.

However, when the piezoelectric element is prepared by using a current mainstream preparation process, if miniaturization, low-voltage driving, and high-speed driving are achieved, a manufacturing error of the piezoelectric element is large, and consequently, a deviation between piezoelectric elements is large.

### SUMMARY

Embodiments of this application provide a piezoelectric element and a preparation method therefor, a piezoelectric device, and an electronic device, to reduce a manufacturing error of the piezoelectric element and improve uniformity of piezoelectric elements.

To achieve the foregoing objective, this application uses the following technical solutions.

According to a first aspect of embodiments of this application, a piezoelectric element is provided, and used in a MEMS device like an actuator or a sensor. The piezoelectric element includes a substrate, a vibration plate, and a plurality of piezoelectric elements. The substrate has a plurality of cavities that penetrate the substrate along a thickness direction, the plurality of cavities are sequentially arranged along a first direction of the substrate, and the substrate is a monocrystalline silicon substrate. The vibration plate covers the substrate and the plurality of cavities. The piezoelectric unit includes a first electrode, a piezoelectric layer, and a second electrode that are stacked on a side that is of the vibration plate and that is away from the substrate, projection of the piezoelectric unit on the vibration plate overlaps projection of the cavity on the vibration plate, and a value of the first direction deviates within a range of ±15° of a <100> crystal orientation of the substrate. It should be understood that the value of the first direction may be within the foregoing range, but a value of the first direction in a same piezoelectric element is the same and fixed, and only one fixed value can be selected from the range. Values of the first direction in different piezoelectric elements may be different.

In the piezoelectric element provided in embodiments of this application, an arrangement direction of the plurality of cavities in the substrate deviates within the range of ±15° of the <100> crystal orientation of the substrate. In the deviation range of ±15° of the <100> crystal orientation of the substrate, a value of E/(1-v²) of the vibration plate is small, and the value of E/(1-v²) of the vibration plate is the smallest in the <100> crystal orientation of the substrate. Therefore, after the plurality of cavities are arranged along the foregoing direction, a thickness of the vibration plate can be increased when a value of bending stiffness is fixed. After the thickness of the vibration plate is increased, a variation of the thickness of the vibration plate poses less impact on the overall thickness of the vibration plate in a preparation process, to reduce impact of a film thickness deviation, a film quality deviation, and a mechanical performance deviation of the vibration plate on uniformity of the piezoelectric elements. This helps reduce a performance deviation and a performance variation of the piezoelectric element that are caused by the film thickness deviation, the film quality deviation, and the mechanical performance deviation of the vibration plate while implementing miniaturization and high density of the piezoelectric elements.

In a possible implementation, the first direction is a direction in which the value of E/(1-v²) of the vibration plate is the smallest, E is a Young's modulus of the vibration plate, and v is a Poisson's ratio of the vibration plate. The plurality of cavities are arranged along the direction in which the value of E/(1-v²) of the vibration plate is the smallest, to minimize impact of the film thickness deviation, the film quality deviation, and the mechanical performance deviation of the vibration plate on uniformity of the piezoelectric elements.

In a possible implementation, a cross section that is of the cavity and that is parallel to the substrate is a strip pattern, and the plurality of cavities are arranged along a direction parallel to a short side of the strip pattern. The cross section of the cavity is set to be a strip pattern, to balance a large displacement amount and a small gap while meeting requirements of the piezoelectric element. For example, when the piezoelectric element is used in an inkjet printhead of a printer, a cavity needs to be large enough to generate sufficient vibration displacement and pressure. Therefore, a large displacement amount is required. Each cavity is connected to an inkjet nozzle on the outside, and a gap between inkjet nozzles needs to be small enough to meet an actual printing requirement. Therefore, a small gap is required.

In a possible implementation, the thickness of the vibration plate ranges from 0.5 µm to 5 µm. A thin vibration plate causes insufficient stiffness of the vibration plate, and consequently, the vibration plate is too soft, and cannot provide a stable vibration characteristic. A thick vibration plate causes high stiffness of the vibration plate, and consequently, the vibration plate is excessively stiff, and cannot implement a required vibration response. The thickness of the vibration plate is selected to be within a range of 0.5 µm to 5 µm, so that the vibration plate has moderate stiffness, and can be used as an etching barrier layer.

In a possible implementation, the vibration plate is a film layer formed by a monocrystalline material. A displacement change generated by the vibration plate directly causes a change of a volume of a cavity. However, in this application, the vibration plate is set to be the film layer formed by the monocrystalline material, to increase uniformity of the Young's moduli and the Poisson's ratios of the vibration plate. This can improve uniformity of quality of the film layers of the vibration plate.

In a possible implementation, the monocrystalline material includes a monocrystalline oxide. A vibration plate prepared by using the monocrystalline oxide is of a simple structure.

In a possible implementation, a crystal orientation of the vibration plate is the same as the crystal orientation of the substrate. A crystallization direction of the vibration plate is determined by a direction of the substrate. When the crystal orientation of the vibration plate is the same as that of the substrate, a smaller value of E/(1-v²) of the vibration plate in a direction deviating within the range of ±15° of the <100> crystal orientation, to greatly reduce the performance deviation and the performance variation of the piezoelectric element.

In a possible implementation, the substrate is of a (100) orientation, and a flat edge of the substrate is in a <110> or <100> direction. The piezoelectric element in this application is applicable to the substrate of a (100) orientation.

In a possible implementation, the substrate is of a (110) orientation, and the flat edge of the substrate is in a <110>, <100>, or <111> direction. The piezoelectric element in this application is also applicable to the substrate of a (110) orientation.

According to a second aspect of embodiments of this application, a piezoelectric device is provided, and includes a drive circuit and the piezoelectric element in any implementation of the first aspect. The drive circuit is electrically connected to the piezoelectric element.

The piezoelectric device provided in the second aspect in embodiments of this application includes the piezoelectric element in the first aspect. Beneficial effect of the piezoelectric device is the same as beneficial effect of the piezoelectric element. Details are not described herein again.

According to a third aspect of embodiments of this application, an electronic device is provided, and includes a housing and the piezoelectric device in the second aspect. The piezoelectric device is disposed in the housing.

The electronic device provided in the third aspect in embodiments of this application includes the piezoelectric element in the first aspect. Beneficial effect of the electronic device is the same as beneficial effect of the piezoelectric element. Details are not described herein again.

According to a fourth aspect of embodiments of this application, a preparation method for a piezoelectric element is provided, and includes: providing a substrate, where the substrate is a monocrystalline silicon substrate; forming a vibration plate on one side of the substrate, where the vibration plate covers the substrate; forming a plurality of piezoelectric units on a side that is of the vibration plate and that is away from the substrate, where projection of the piezoelectric unit on the vibration plate overlaps projection of a cavity on the vibration plate, and the piezoelectric unit includes a first electrode, a piezoelectric layer, and a second electrode that are stacked on the side that is of the vibration plate and that is away from the substrate; and forming, on the substrate, a plurality of cavities that penetrate the substrate, where the plurality of cavities are sequentially arranged along a first direction of the substrate, and a value of the first direction deviates within a range of ±15° of a <100> crystal orientation of the substrate.

Beneficial effect of the electronic device provided in the fourth aspect in embodiments of this application is the same as beneficial effect of the piezoelectric element in the first aspect. Details are not described herein again.

In a possible implementation, the forming the vibration plate on the side of the substrate includes: forming the vibration plate on the side of the substrate by using an epitaxial growth process. A crystal orientation of the vibration plate formed by using the epitaxial growth process is the same as a crystal orientation of the substrate, and lattice matching is implemented between the vibration plate and the substrate.

In a possible implementation, a thickness of the vibration plate ranges from 0.5 µm to 5 µm.

In a possible implementation, the vibration plate is a film layer formed by depositing a monocrystalline material.

In a possible implementation, a material of the vibration plate includes a monocrystalline oxide.

### BRIEF DESCRIPTION OF DRAWINGS

FIG. 1 is a diagram of an architecture of an electronic device according to an embodiment of this application;
FIG. 2A is a diagram of a structure of a piezoelectric element according to an embodiment of this application;
FIG. 2B is a diagram of a structure of another piezoelectric element according to an embodiment of this application;
FIG. 3 is a schematic flowchart of a preparation procedure for a piezoelectric element according to an embodiment of this application;
FIG. 4 to FIG. 8 are diagrams of a preparation process for a piezoelectric element according to an embodiment of this application;
FIG. 9A is a curve diagram of a Young's modulus of a vibration plate according to an embodiment of this application;
FIG. 9B is a curve diagram of a Poisson's ratio V of a vibration plate according to an embodiment of this application;
FIG. 9C is a curve diagram of $\frac{E}{1 - {ν}^{2}}$ of a vibration plate according to an embodiment of this application;
FIG. 9D is a curve diagram of a Young's modulus of another vibration plate according to an embodiment of this application;
FIG. 9E is a curve diagram of a Poisson's ratio V of another vibration plate according to an embodiment of this application;
FIG. 9F is a curve diagram of $\frac{E}{1 - {ν}^{2}}$ of another vibration plate according to an embodiment of this application;
FIG. 10 is a diagram of an arrangement manner of cavities according to an embodiment of this application; and
FIG. 11 is a top view of a piezoelectric element according to an embodiment of this application.

### DESCRIPTION OF EMBODIMENTS

The following describes technical solutions in embodiments of this application with reference to accompanying drawings in embodiments of this application. It is clear that the described embodiments are merely a part rather than all of embodiments of this application.

Terms such as "second" and "first" below are only for ease of description, and cannot be understood as indicating or implying relative importance or implicitly indicating a quantity of indicated technical features. Therefore, a feature limited by "second", "first", or the like may explicitly or implicitly include one or more features. In the descriptions of this application, unless otherwise stated, "a plurality of" means two or more than two.

In addition, in embodiments of this application, orientation terms such as ''upper'', ''lower'', "left", and "right" may include but are not limited to definitions based on illustrated orientations in which components in the accompanying drawings are placed. It should be understood that, these directional terms may be relative concepts. They are used for description and clarification of relative locations, and may vary accordingly depending on a change in the orientations in which the components in the accompanying drawings are placed in the accompanying drawings.

In embodiments of this application, unless otherwise clearly specified and limited, a term "connection" should be understood in a broad sense. For example, the "connection" may be a fixed connection, a detachable connection, or an integral connection, may be a direct connection, or may be an indirect connection through an intermediate medium. In addition, a term "coupling" may be a direct electrical connection, or may be an indirect electrical connection through an intermediate medium. A term "contact" may be direct contact or indirect contact through an intermediate medium.

In embodiments of this application, "and/or" describes an association relationship between associated objects, and indicates that three relationships may exist. For example, A and/or B may indicate the following cases: Only A exists, both A and B exist, and only B exists, where A and B may be singular or plural. The character "/" usually indicates an "or" relationship between the associated objects.

With development of science and technology, electronic systems, mechanical systems, and the like develop towards miniaturization. High-density, multi-functional, and intelligent integration of chips become important research directions, and a micro-electro mechanical systems (micro-electro mechanical systems, MEMS) technology featuring miniaturization, integration, and intelligence emerges. Electromechanical conversion piezoelectric devices such as actuators, sensors, micro-optical systems, radio frequency systems, microbial chips, microfluidic devices, and three-dimensional integrated circuits based on the MEMS technology have been widely used in fields such as industry, biology, and medicine.

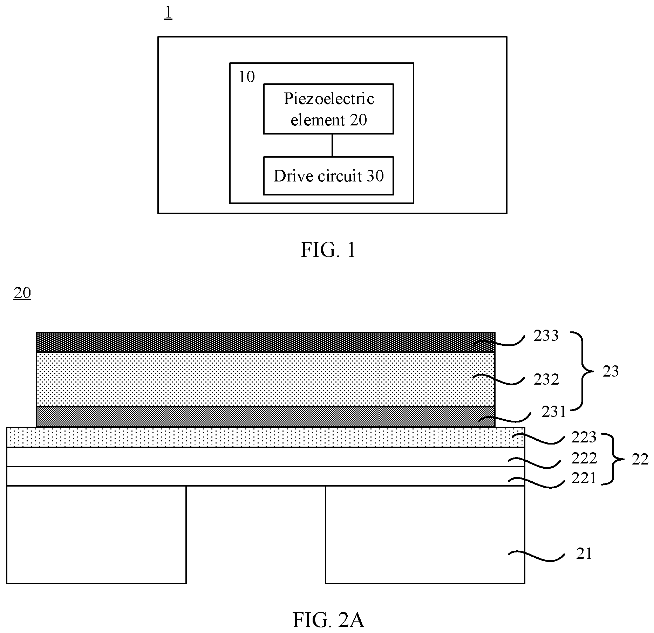

An embodiment of this application provides an electronic device. As shown in FIG. 1, an electronic device 1 may be an electronic product that includes a piezoelectric device 10 that requires a high drive voltage and a large deformation amount (displacement amount). The piezoelectric device 10 is, for example, a sensor or an actuator. For example, the piezoelectric device 10 includes a MEMS micromirror, a MEMS microphone, a MEMS speaker, a micro pump, an inkjet printhead, an ultrasonic sensor, and a MEMS radio frequency device.

In some embodiments, the electronic device 1 includes a housing, and the piezoelectric device 10 is disposed in the housing. For example, the electronic device 1 may be a device like a projector, a radar, a mobile phone, a headset, a heat sink, a printer, or a B-mode ultrasound scanner. A specific form of the electronic device 1 is not limited in embodiments of this application.

For example, the electronic device 1 is a printer, and the piezoelectric device 10 is used in the printer as an inkjet printhead of the printer.

An embodiment of this application provides a piezoelectric device 10. As shown in FIG. 1, the piezoelectric device 10 includes a piezoelectric element 20 and a drive circuit 30. The drive circuit 30 is configured to provide a drive voltage (which may be a direct current voltage or an alternating current voltage) for the piezoelectric element 20, so that an electric field is generated in the piezoelectric element 20. The piezoelectric element 20 converts electric energy into mechanical energy under action of the electric field, so that the piezoelectric element 20 generates an output of mechanical displacement or force.

It may be understood that the piezoelectric device 10 may further include another device. For example, the piezoelectric device 10 further includes a processor. The processor may detect the mechanical displacement or the force output by the piezoelectric element 20, and adjust a voltage applied by the drive circuit 30, to control required movement or force.

In recent years, piezoelectric materials such as lead zirconate titanate (Pb(Zr,Ti)O₃, PZT) are widely used in piezoelectric elements 20. The piezoelectric material is formed on a substrate like silicon/silicon dioxide in a thin film form, and then MEMS processing is performed, to form a miniaturized and high-performance piezoelectric element 20.

FIG. 2A is a diagram of a structure of a piezoelectric element according to an embodiment of this application.

An embodiment of this application shows a piezoelectric element 20. As shown in FIG. 2A, the piezoelectric element 20 includes a substrate 21, a vibration plate 22, and a piezoelectric unit 23. The piezoelectric unit 23 includes a first electrode 231, a piezoelectric layer 232, and a second electrode 233 that are stacked on a side that is of the vibration plate 22 and that is away from the substrate 21.

A voltage may be applied to the first electrode 231 and the second electrode 233, so that an electric field can be formed between the first electrode 231 and the second electrode 233. Under influence of the electric field, the piezoelectric layer 232 deforms, and the vibration plate 22 vibrates, to convert electric energy into mechanical energy under reverse piezoelectric effect.

The piezoelectric layer 232 is a perovskite oxide film including Pb, Zr, and Ti, and a crystallographic preferred orientation of the piezoelectric layer 232 is <100> or <001>. The vibration plate 22 is formed on the substrate 21 whose material is silicon (Si) by using a sputtering method, a thermal treatment film forming method, and a low pressure chemical vapor deposition (low pressure chemical vapor deposition, LPCVD) method. The vibration plate 22 is a layered structure including a silicon nitride layer 221, a silicon oxide layer 222, and a polysilicon layer 223.

If the vibration plate 22 is formed by using the sputtering method, the thermal treatment film forming method, or the LPCVD method, an obtained film layer is in an amorphous state, and Young's moduli of the film layers in the amorphous state are uneven. In addition, uniformity of quality of the formed film layers also varies due to impact of a deposition condition and a cavity condition. Consequently, it is difficult to maintain a constant Young's modulus and a constant Poisson's ratio during manufacturing. When a miniaturized and high-density piezoelectric element 20 is required, the vibration plate 22 needs to be thinner, and it is more difficult to ensure uniformity of the quality of the film layers.

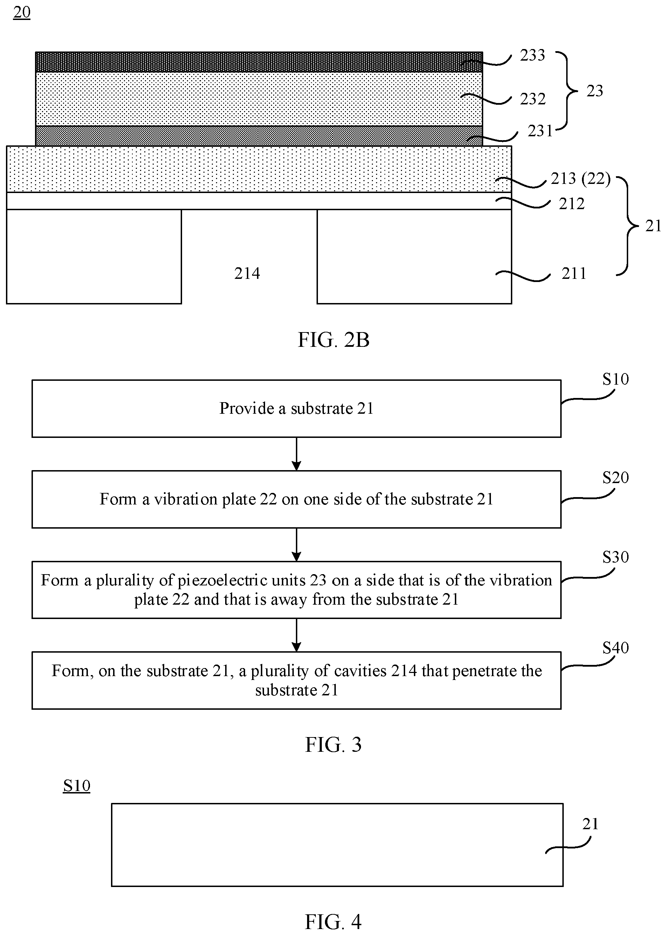

FIG. 2B is a diagram of a structure of a piezoelectric element according to an embodiment of this application.

An embodiment of this application shows a piezoelectric element 20. As shown in FIG. 2B, the piezoelectric element 20 includes a substrate 21, a vibration plate 22, and a piezoelectric unit 23. The piezoelectric unit 23 includes a first electrode 231, a piezoelectric layer 232, and a second electrode 233 that are stacked on a side that is of the vibration plate 22 and that is away from the substrate 21.

The substrate 21 is a silicon on insulator (silicon on Insulator, SOI) substrate, and the SOI substrate includes a base layer 211, an insulation layer 212, and a component silicon layer 213 that are stacked. The substrate 21 includes cavities 214 that penetrate the base layer 211, and the cavity 214 provides vibration space for the component silicon layer 213 of the vibration plate. The insulation layer 212 is located between the base layer 211 and the component silicon layer 213, and is configured to implement electrical isolation between the substrate and the component silicon layer. The insulation layer 212 may be a silicon oxide layer obtained through thermal oxidation growth or chemical vapor deposition (chemical vapor deposition, CVD). The component silicon layer 213 is reused as the vibration plate 22 of the piezoelectric element 20, and a thickness of the component silicon layer 213 may be flexibly set based on requirements of different actuators for the vibration plate.

A process of manufacturing the piezoelectric element 20 is as follows: First, an SOI substrate is formed. Then, the piezoelectric unit 23 is formed on the component silicon layer 213 of the SOI substrate. Finally, the base layer 211 is etched on a side that is of the base layer 211 and that is away from the insulation layer 212, to form cavities 214 that penetrate the base layer 211, and the insulation layer 212 is used as an etching stop layer.

The vibration plate 22 is made of a monocrystalline silicon-based material, and a Young's modulus of the vibration plate 22 varies with a direction in a crystal plane. A short side direction of the vibration plate 22 is aligned with a specific direction, so that the Young's modulus of the vibration plate 22 along the short side direction is less than a Young's modulus along a long side direction. Therefore, the vibration plate 22 is more likely to deform, to enhance a displacement characteristic of the piezoelectric element.

An active layer substrate of the vibration plate 22 is formed by using the monocrystalline silicon-based material, to resolve uneven film quality of the vibration plate 22 in FIG. 2A. However, the piezoelectric element 20 needs to use an SOI substrate, and the SOI substrate is usually a substrate that is formed in advance. To meet requirements of different types of piezoelectric elements 20 for the thickness of the vibration plate 22, the component silicon layer 213 usually needs to be thinned by using a polish process, so that the component silicon layer 213 has a preset thickness. However, the polish process causes a large film thickness deviation of the component silicon layer 213, and a film thickness error of the polish process is usually ±0.5 µm. The error directly causes an error of the piezoelectric element 20. It is proposed that the Young's modulus of the vibration plate 22 varies with the direction in the crystal plane to increase sensitivity of the thickness of the vibration plate 22 to vibration displacement, and reduce a relative change by thickening the vibration plate 22, but this still cannot avoid a thickness deviation and a uniformity problem caused by the polish process.

In view of this, embodiments of this application further provide a piezoelectric element 20 and a preparation method therefor, to reduce a manufacturing error of the piezoelectric element 20 and improve uniformity of piezoelectric elements 20.

FIG. 3 is a schematic flowchart of a preparation procedure for a piezoelectric element according to an embodiment of this application. FIG. 4 to FIG. 8 are diagrams of a preparation process for a piezoelectric element according to an embodiment of this application.

An embodiment of this application further provides a preparation method for a piezoelectric element 20. As shown in FIG. 3, the preparation method includes the following steps.

S10: Provide a substrate 21, as shown in FIG. 4.

The piezoelectric element 20 provided in this embodiment of this application includes the substrate 21, and the substrate 21 is a monocrystalline silicon substrate.

A thickness of the substrate 21 is not limited in embodiments of this application. For example, the thickness of the substrate 21 may be a standard thickness of 300 µm to 800 µm.

A diameter of the substrate 21 is not limited in embodiments of this application. The substrate 21 may be a large-sized substrate 21 with a diameter like 8 inches or 12 inches, or may be a small-sized substrate 21.

In addition, an orientation of the substrate 21 is not limited in embodiments of this application, and the monocrystalline silicon substrate may be of a (100) or (110) orientation.

Compared with the SOI substrate, the monocrystalline silicon substrate has a simple manufacturing process and low costs. In addition, the monocrystalline silicon substrate has good mechanical characteristics. For example, the monocrystalline silicon substrate features high mechanical strength, high linearity, and low creep, and has small internal stress. This can improve the displacement and the force or a rotation angle output by the actuator, and implement better linearity, consistency, and reliability.

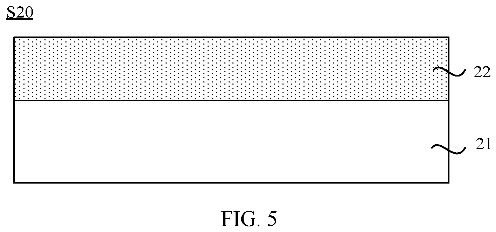

S20: Form a vibration plate 22 on one side of the substrate 21, as shown in FIG. 5.

In some embodiments, the vibration plate 22 is formed on one side of the substrate 21 by using an epitaxial growth process, and an orientation of the vibration plate 22 is the same as the orientation of the substrate 21. For example, the vibration plate 22 is formed by using a metal organic chemical vapor deposition (metal organic chemical vapor deposition, MOCVD) process, an electron beam evaporation process, a magnetron sputtering process, or another applicable process, and the orientation of the vibration plate 22 may be (100) or (110).

The piezoelectric element 20 provided in this embodiment of this application includes the vibration plate 22. The vibration plate 22 covers one side of the substrate 21, and a material of the vibration plate 22 is different from a material of the substrate 21.

In some embodiments, the vibration plate 22 is a film layer formed by a monocrystalline material.

In some embodiments, the material of the vibration plate 22 includes a monocrystalline oxide. For example, the material of the vibration plate 22 includes a perovskite metal oxide. For example, the material of the vibration plate 22 includes one or a combination of the following: zirconium dioxide (ZrO₂), yttria-stabilized zirconia (YSZ), hafnium oxide (HfO₂), and hafnium zirconium oxide (HfZrO₂).

A displacement change generated by the vibration plate 22 directly causes a change of a volume of a cavity 214. However, in this application, the vibration plate 22 is set to be the film layer formed by the monocrystalline material, to increase uniformity of the Young's moduli and the Poisson's ratios of the vibration plate 22. This can improve uniformity of quality of the film layers of the vibration plate 22.

Because stiffness of the vibration plate 22 has important impact on a natural frequency and a resonance frequency of the vibration plate 22, higher stiffness can increase the natural frequency of the vibration plate 22, to improve frequency stability of the vibration plate 22. In addition, sensitivity of the vibration plate 22 is an important indicator that affects performance of the piezoelectric element 20, and higher stiffness can make the vibration plate 22 more sensitive to external excitation, that is, more likely to generate displacement or a response, to improve performance of the piezoelectric element 20.

In view of this, in some embodiments, the thickness of the vibration plate 22 ranges from 0.5 µm to 5 µm, so that the vibration plate 22 has proper stiffness. For example, the thickness of the vibration plate 22 is 1 µm, 1.5 µm, 2 µm, 2.5 µm, 3 µm, 3.5 µm, 4 µm, or 4.5 µm.

A thin vibration plate 22 causes insufficient stiffness of the vibration plate 22, and consequently, the too soft vibration plate 22 cannot provide a stable vibration characteristic. A thick vibration plate 22 causes high stiffness of the vibration plate 22, and consequently, the excessively stiff vibration plate 22 cannot implement a required vibration response. The thickness of the vibration plate 22 is selected to be within a range of 0.5 µm to 5 µm, so that the vibration plate 22 has moderate stiffness, and can be used as an etching barrier layer.

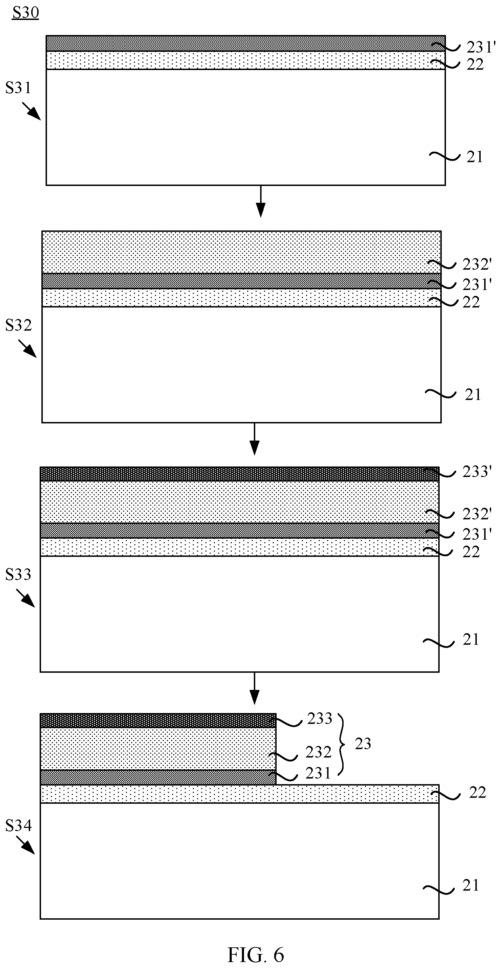

S30: Form a plurality of piezoelectric units 23 on a side that is of the vibration plate 22 and that is away from the substrate 21, as shown in FIG. 6.

The piezoelectric element 20 provided in this embodiment of this application further includes the piezoelectric units 23. The piezoelectric unit 23 includes a first electrode 231, a piezoelectric layer 232, and a second electrode 233 that are stacked on the side that is of the vibration plate 22 and that is away from the substrate 21.

In some embodiments, step S30 includes the following steps.

S31: Form a first electrode film 231' on the side that is of the vibration plate 22 and that is away from the substrate 21.

When the piezoelectric element 20 is used in the piezoelectric device 10, the piezoelectric element 20 needs to be miniaturized, driven by a low voltage, and driven at a high speed. The piezoelectric element 20 with a higher piezoelectric constant can be driven more efficiently with an input voltage. However, a larger capacitance of the piezoelectric element 20 indicates greater power consumption during driving and higher heat generation of the element. Therefore, the piezoelectric element 20 used in the piezoelectric device 10 needs to have a higher piezoelectric constant and a lower dielectric constant. The crystal orientation of the piezoelectric unit 23 greatly affects piezoelectric characteristics of the piezoelectric element 20, especially the piezoelectric characteristics such as conversion efficiency, the dielectric constant, and a dielectric loss. Therefore, a film forming state of the first electrode film 231' is also important.

In some embodiments, the first electrode film 231' may be formed on the side that is of the vibration plate 22 and that is away from the substrate 21 by using a sputtering process or an electron evaporation process. A material of the first electrode film 231' may be a polysilicon material or a metal material. The metal material may include one or a combination of the following: platinum (Pt), gold (Au), copper (Cu), and aluminum (Al).

In some embodiments, an orientation of the first electrode film 231' is the same as the orientation of the vibration plate 22. For example, the first electrode film 231' is of a (100) or (110) orientation. The orientation of the first electrode film 231' is the same as the orientation of the vibration plate 22, so that the piezoelectric layer 232 subsequently formed can have a good piezoelectric characteristic.

It may be understood that the first electrode film 231' being of a (100) orientation means that an orientation of more than half of crystals in the first electrode film 231' is (100). For example, an orientation of 90% of crystals in the first electrode film 231' is (100). There may be a small quantity of crystals in the first electrode film 231' that have another orientation, for example, (001). Similarly, the first electrode film 231' being of a (110) orientation means that an orientation of more than half of crystals in the first electrode film 231' is (110). For example, an orientation of 90% of crystals in the first electrode film 231' is (110). There may be a small quantity of crystals in the first electrode film 231' that have another orientation.

In some embodiments, a thickness of the first electrode film 231' ranges from 100 nm to 200 nm. For example, the thickness of the first electrode film 231' is 110 nm, 120 nm, 130 nm, 140 nm, 150 nm, 160 nm, 170 nm, 180 nm, or 190 nm.

In some embodiments, before step S32 in the following is performed, the preparation method further includes: forming a buffer layer on the first electrode film 231' by using a sputtering process, a chemical solution deposition process, or another proper process.

An orientation of the buffer layer is the same as the orientation of the first electrode film 231', to ensure that the piezoelectric layer 232 subsequently formed has a good piezoelectric characteristic. The buffer layer may be used as an adhesion layer between the first electrode film 231' and a piezoelectric film 232', to prevent the piezoelectric film 232' from being peeled off from the first electrode film 231'. In addition, the buffer layer may also be used as a barrier layer, to prevent a material that is subsequently used to form the piezoelectric film 232' from diffusing into the first electrode film 231'.

S32: Form the piezoelectric film 232' on a side that is of the first electrode film 231' and that is away from the vibration plate 22.

The piezoelectric film 232' includes, for example, one or more perovskite structures such as strontium ruthenate (Sr₂RuO₄, SRO), lead lanthanum titanate ((Pb,La)TiO₃, PLT), and lanthanum nickel oxide (LaNiO₃, LNO).

In some embodiments, step S32 includes the following steps.

S321: Deposit a precursor solution of the piezoelectric film 232' on the first electrode film 231'.

For example, the precursor solution of the piezoelectric film 232' is formed by using the chemical solution deposition method, the sputtering method, a spin coating method, or another proper process. For example, a spin coater coats the precursor solution obtained through a sol-gel method on the substrate 21 at a rotational speed of 2000 rpm to 3000 rpm. The precursor solution of the piezoelectric film 232' can have an expected thickness by controlling the rotational speed, time, liquid amount, and the like. A material in the precursor solution of the piezoelectric film 232' may include one or more perovskite structures such as SRO, PLT, and LNO.

S322: Dry the precursor solution, to form a thin film layer.

For example, the precursor solution is heated for about 10 minutes to 30 minutes at about 100°C to 150°C by using a hot plate or an electric furnace, to burn and remove organic matter and water in the precursor solution.

S323: Perform pre-sintering on the thin film layer, to form an inorganic film layer.

For example, the thin film layer is heated for about 10 minutes to 30 minutes at about 200°C to 450°C by using the hot plate or the electric furnace, to thermally decompose residual organic matter.

S324: Perform calcination on the inorganic film layer, to form a monocrystalline seed layer.

For example, calcination is performed on the inorganic film layer for 5 minutes to 30 minutes at about 600°C to 700°C through rapid thermal annealing (rapid thermal annealing, RTA) or another proper process, until an expected film thickness for a perovskite-type single crystal is reached. During calcination, specific gas such as oxygen is introduced, and sintering is performed under pressure, to obtain a denser monocrystalline seed layer.

S321 to S324 are repeated until the piezoelectric film 232' with a required thickness is formed. For example, the thickness of the piezoelectric film 232' ranges from 1 µm to 5 µm.

In most cases, the PZT material is a crystal formed by lead (Pb), zirconium (Zr), titanium (Ti), and oxygen (O). PZT with a perovskite structure shows good piezoelectric effect. An ideal perovskite structure is a cubic lattice, and is formed by metals such as Pb configured at each vertex (site A) of the cubic crystal, Zr and Ti configured at each body center (site B), and O configured at each face center (site C) of the cubic crystal, to form an ABO₃ crystal. Zr and Ti occupy the same position, but a ratio is adjustable. Crystals with the perovskite structure also includes a tetragonal crystal, an orthorhombic crystal, a rhombohedral crystal, and the like that are deformed from a cubic crystal. In addition, an orientation of the crystal greatly affects piezoelectric characteristics, especially the piezoelectric characteristics such as the conversion efficiency, the dielectric constant, and the dielectric loss. Therefore, to control the orientation or crystallinity, it is important to control film forming states of the first electrode film 231' and the piezoelectric film 232' in the film forming process.

In this embodiment of this application, to enable the PZT material in the piezoelectric film 232' to have a single-phase perovskite structure, a crystal structure of the material in the first electrode film 231' is first made to be similar to the single-phase perovskite structure by using the foregoing manufacturing process. The orientation of the piezoelectric film 232' that uses the PZT material is the same as the orientation of the first electrode film 231', so that the PZT material in the piezoelectric film 232' is of the single-phase perovskite structure. In other words, the piezoelectric film 232' is also of a (100) or (110) orientation. Lattice matching is implemented between the piezoelectric film 232' and the first electrode film 231', so that the piezoelectric film 232' with the orientation has a good piezoelectric characteristic, that is, has a high piezoelectric constant and a low dielectric constant. The piezoelectric film 232' deforms under reverse piezoelectric effect and action of an electric field, to convert electrical energy into mechanical energy. This implements various functions of an actuator.

In some embodiments, before step S33 in the following is performed, the preparation method further includes: forming a buffer layer on the piezoelectric film 232' by using the sputtering process, the chemical solution deposition process, or another proper process.

The buffer layer may be used as an adhesion layer between the piezoelectric film 232' and a second electrode film 233', to prevent the piezoelectric film 232' from being peeled off from the second electrode film 233'. In addition, the buffer layer may also be used as a barrier layer, to prevent the material used to form the piezoelectric film 232' from diffusing into the second electrode film 233'.

S33: Form the second electrode film 233' on a side that is of the piezoelectric film 232' and that is away from the first electrode film 231'.

For example, the second electrode film 233' is formed on the piezoelectric film 232' by using the sputtering process or the electron evaporation process. A material of the second electrode film 233' may be a polysilicon material, a metal material, or an oxide material. The material of the second electrode film 233' may include one or a combination of the following: Pt, Au, Cu, Al, and iridium dioxide (IrO₂).

S34: Perform patterning processing on the second electrode film 233', the piezoelectric film 232', and the first electrode film 231', to form a patterned second electrode 233, piezoelectric layer 232, and first electrode 231, to form the piezoelectric unit 23.

For example, the second electrode film 233', the piezoelectric film 232', and the first electrode film 231' are patterned by using a patterning process. The patterning process includes a photolithography process, an etching process, and the like. For example, the photolithography process includes photoresist coating (such as spin coating), soft baking, mask alignment, exposure, post-exposure baking, photoresist development, rinse, and drying (such as hard baking). For example, the etching process includes a dry etching process or a wet etching process.

It should be understood that, the second electrode film 233', the piezoelectric film 232', and the first electrode film 231' may be patterned in one patterning processing procedure, or the second electrode film 233', the piezoelectric film 232', and the first electrode film 231' may be patterned separately. This is not limited in embodiments of this application. Sizes of the second electrode 233, the piezoelectric layer 232, and the first electrode 231 along a direction parallel to the substrate 21 vary with a pattern processing procedure. FIG. 6 shows only an example in which the second electrode 233, the piezoelectric layer 232, and the first electrode 231 have the same size along the direction parallel to the substrate 21 for illustration.

As shown in FIG. 6, the piezoelectric element 20 provided in this embodiment of this application includes the piezoelectric units 23. The piezoelectric unit 23 includes the first electrode 231, the piezoelectric layer 232, and the second electrode 233 that are sequentially disposed on the side that is of the vibration plate 22 and that is away from the substrate 21. Certainly, the piezoelectric unit 23 may further add another film layer based on the first electrode 231, the piezoelectric layer 232, and the second electrode 233. For example, a buffer layer may be further disposed between the first electrode 231 and the piezoelectric layer 232, and a buffer layer may be further disposed between the piezoelectric layer 232 and the second electrode 233. A structure of the piezoelectric unit 23 shown in this embodiment of this application is merely an example, and does not constitute any limitation.

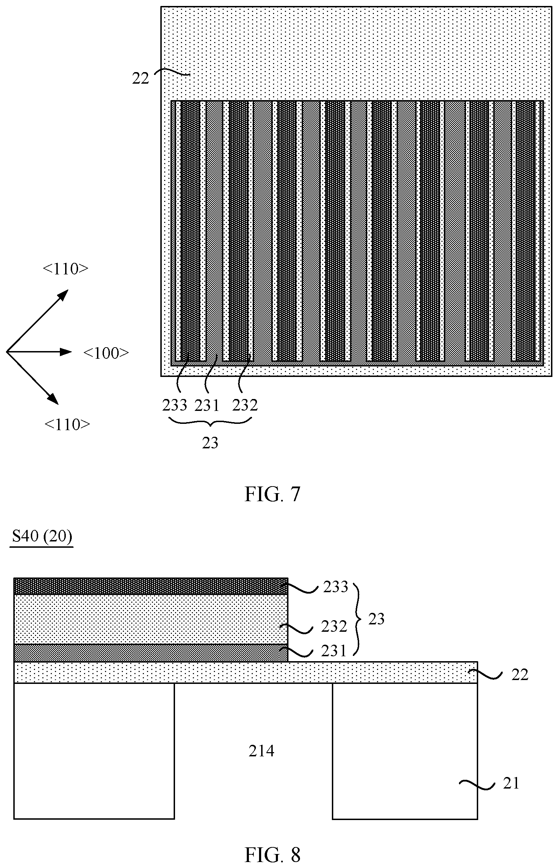

In some embodiments, as shown in FIG. 7, a plurality of first electrodes 231 of the plurality of piezoelectric units 23 included in the piezoelectric element 20 are coupled to each other. In this case, when the first electrode film 231', the second electrode film 233', and the piezoelectric film 232' are patterned, a pattern of the first electrode film 231' is different from patterns of the second electrode film 233' and the piezoelectric film 232'. For example, the plurality of first electrodes 231 of the plurality of piezoelectric units 23 are connected to form a sheet-like structure.

In some embodiments, the piezoelectric element 20 further includes a pad (pad) and a trace that are coupled to the first electrode 231 and the second electrode 233. For example, both the pad and the trace are disposed at a same layer as the second electrode 233 and are simultaneously formed with the second electrode 233. Alternatively, for example, the pad and the trace are disposed at different layers from the second electrode 233, and the pad and the trace are located on a side that is of the second electrode 233 and that is away from the substrate 21. For example, the pad and the trace are disposed at a same layer, and an insulation layer is disposed between the layer at which the pad and the trace are located and the layer at which the second electrode 233 is located. Alternatively, the pad and the trace may be disposed at different layers, and an insulation layer may be disposed between the layers at which the pad and the trace are located.

S40: Form, on the substrate 21, a plurality of cavities 214 that penetrate the substrate 21, as shown in FIG. 8.

For example, the substrate 21 is etched on a side that is of the substrate 21 and that is away from the vibration plate 22 by using the photolithography process and a deep silicon etching process, to form, on the substrate 21, the cavities 214 that penetrate the substrate 21. For example, the cavity 214 is formed by using a Bosch (Bosch) process.

In this embodiment of this application, the substrate 21 is etched by using the dry etching process, and the vibration plate 22 is used as an etching stop layer during etching. In other words, when an etching depth reaches the vibration plate 22, because the vibration plate 22 reacts slowly with or does not react with an etching medium, the vibration plate 22 can effectively stop etching, to control the etching depth. Therefore, the cavities 214 that penetrate the substrate 21 are formed. Etching gas is used as the etching medium in the dry etching process. For example, the etching gas includes one or a combination of the following: carbon tetrafluoride (CF₄), argon (Ar), nitrogen trifluoride (NF₃), chlorine (Cl₂), helium (He), hydrogen bromide (HBr), oxygen (O₂), nitrogen (N₂), methyl fluoride (CH₃F), methane (CH₄), and difluoromethane (CH₂F₂).

As shown in FIG. 8, in the piezoelectric element 20 provided in embodiments of this application, the substrate 21 includes the cavities 214, the vibration plate 22 covers the cavities 214, and projection of the piezoelectric unit 23 on the vibration plate 22 overlaps projection of the cavity 214 on the vibration plate 22. In this case, when the substrate 21 includes the plurality of cavities 214, and the piezoelectric element 20 includes the plurality of piezoelectric units 23, the plurality of piezoelectric units 23 are disposed in a one-to-one correspondence with the plurality of cavities 214, and the projection of the piezoelectric unit 23 on the vibration plate 22 overlaps the projection of the correspondingly disposed cavity 214 on the vibration plate 22. FIG. 8 shows only one cavity 214 and one piezoelectric unit 23.

The following describes an arrangement manner of the cavities 214 and the piezoelectric units 23.

A calculation manner of bending stiffness *D* of the vibration plate 22 is shown in the following formula. The bending stiffness *D* is directly proportional to the third power of the film thickness *h* and the Young's modulus *E* of the vibration plate 22, and is inversely proportional to (1 - *v*²). $D = \frac{{Eh}^{3}}{12 \left(1-{ν}^{2}\right)}$

It can be learned from the foregoing formula that a smaller value of $\frac{E}{1 - {ν}^{2}}$ indicates lower bending stiffness *D* and larger displacement of the piezoelectric element 20 when the film thickness *h* of the vibration plate 22 is fixed.

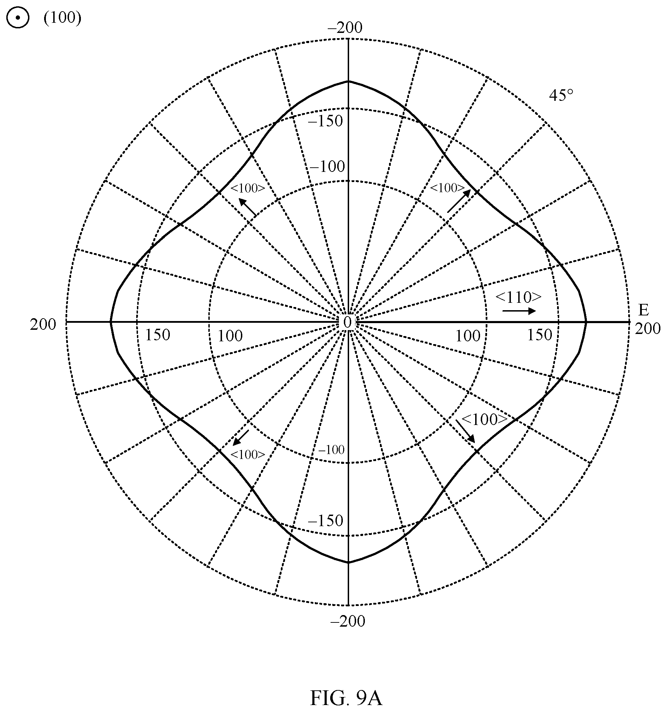

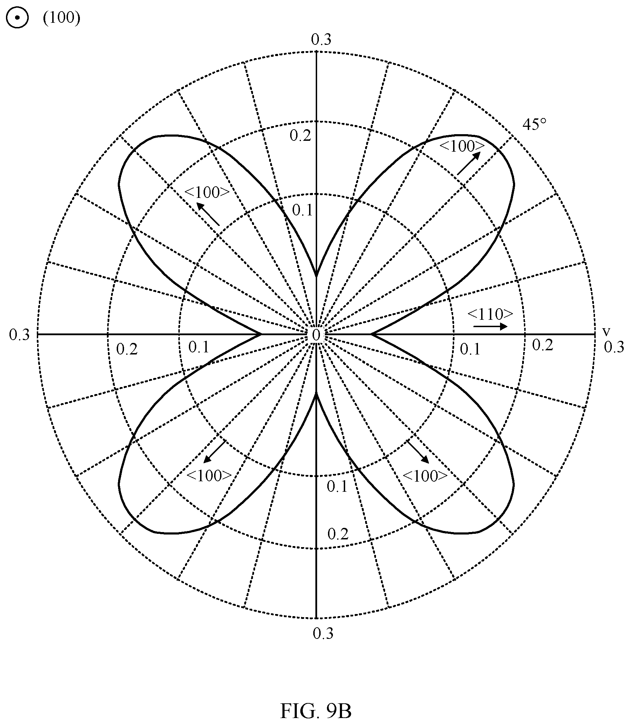

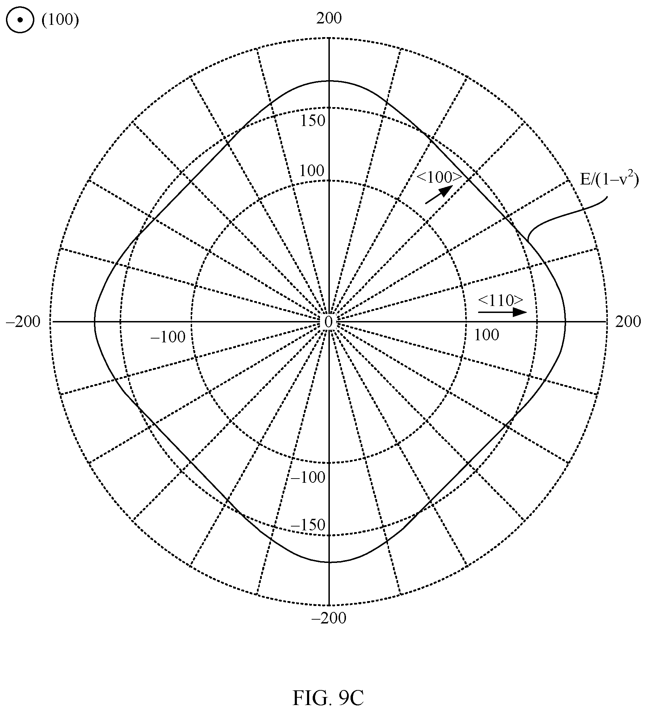

FIG. 9A is a curve diagram of a Young's modulus of a vibration plate according to an embodiment of this application. FIG. 9B is a curve diagram of a Poisson's ratio of a vibration plate according to an embodiment of this application. FIG. 9C is a curve diagram of $\frac{E}{1 - {ν}^{2}}$ of a vibration plate according to an embodiment of this application.

For example, the substrate 21 is of a (100) orientation, and a flat edge of the substrate 21 is in a <110> direction. As shown in FIG. 9A, the Young's modulus *E* of the vibration plate 22 is the smallest in the <100> direction when an included angle between the vibration plate 22 and the flat edge is 45°. As shown in FIG. 9B, the Poisson's ratio *v* of the vibration plate 22 is the largest in the <100> direction when included angle between the vibration plate 22 and the flat edge is 45°. Therefore, as shown in FIG. 9C, the value of $\frac{E}{1 - {ν}^{2}}$ of the vibration plate 22 in the <100> direction is the smallest, and the bending stiffness *D* of $\frac{E}{1 - {ν}^{2}}$ of the vibration plate 22 in the <100> direction is the smallest. In this case, when the cavities 214 and the piezoelectric units 23 are arranged along the <100> direction, deformation can be generated most effectively, and a vibration displacement amount can be increased. It can be learned from the foregoing descriptions that the orientation of the vibration plate 22 is the same as the orientation of the substrate 21. In this case, the value of $\frac{E}{1 - {ν}^{2}}$ of the vibration plate 22 is the smallest in the <100> direction when an included angle between the vibration plate 22 and the flat edge is 45°.

For example, the substrate 21 is of a (100) orientation, and the flat edge of the substrate 21 is of a <100> direction. The Young's modulus *E* of the vibration plate 22 is the smallest, the Poisson's ratio *v* is the largest, and the value of $\frac{E}{1 - {ν}^{2}}$ is the smallest in the <100> direction when the included angle between the vibration plate 22 and the flat edge is 90°.

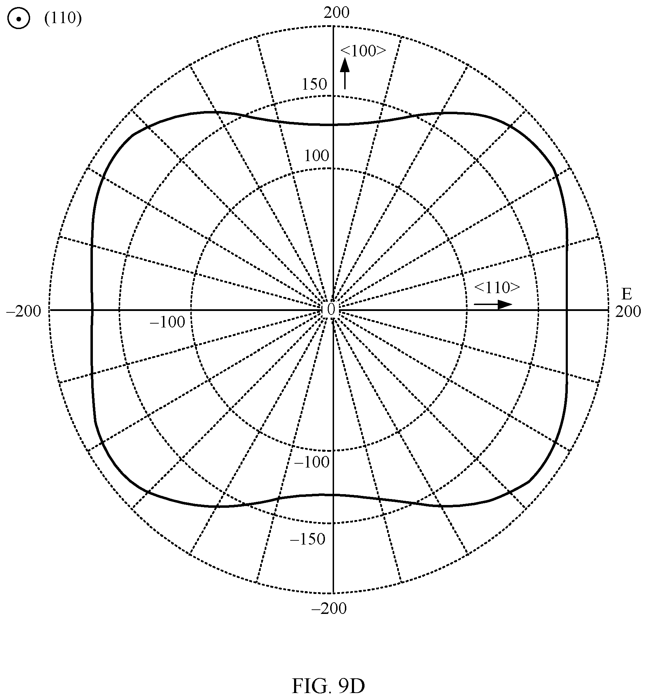

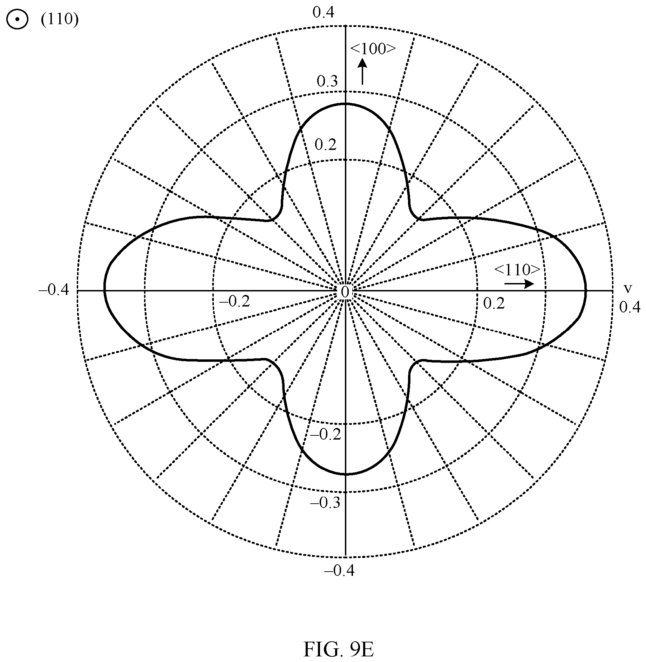

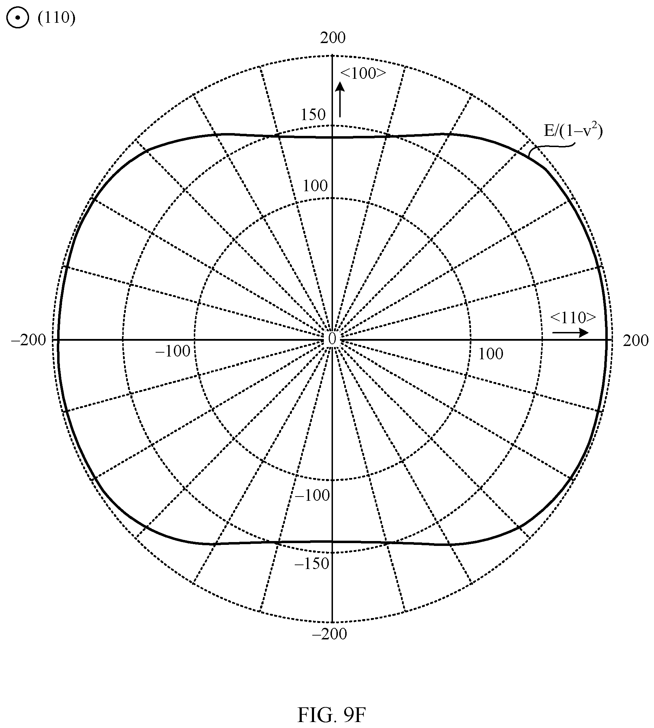

FIG. 9D is a curve diagram of a Young's modulus of a vibration plate according to an embodiment of this application. FIG. 9E is a curve diagram of a Poisson's ratio of a vibration plate according to an embodiment of this application. FIG. 9F is a curve diagram of $\frac{E}{1 - {ν}^{2}}$ of a vibration plate according to an embodiment of this application.

For example, the substrate 21 is of a (110) orientation, and a flat edge of the substrate 21 is in a <110> direction. As shown in FIG. 9D, the Young's modulus *E* of the vibration plate 22 is the smallest in the <100> direction when an included angle between the vibration plate 22 and the flat edge is 90°. As shown in FIG. 9E, the Poisson's ratio *v* of the vibration plate 22 is the largest in the <100> direction when included angle between the vibration plate 22 and the flat edge is 90°. Therefore, as shown in FIG. 9F, the value of $\frac{E}{1 - {ν}^{2}}$ of the vibration plate 22 in the <100> direction is the smallest, and the bending stiffness *D* of $\frac{E}{1 - {ν}^{2}}$ of the vibration plate 22 in the <100> direction is the smallest. In this case, when the cavities 214 and the piezoelectric units 23 are arranged along the <100> direction, deformation can be generated most effectively, and a vibration displacement amount can be increased. It can be learned from the foregoing descriptions that the orientation of the vibration plate 22 is the same as the orientation of the substrate 21. In this case, the value of $\frac{E}{1 - {ν}^{2}}$ of the vibration plate 22 is the smallest in the <100> direction when an included angle between the vibration plate 22 and the flat edge is 90°.

For example, the substrate 21 is of a (110) orientation, and the flat edge of the substrate 21 is in a <110> direction. The Young's modulus *E* of the vibration plate 22 is the smallest, the Poisson's ratio *v* is the largest, and the value of $\frac{E}{1 - {ν}^{2}}$ is the smallest in the <100> direction when the included angle between the vibration plate 22 and the flat edge is 90°.

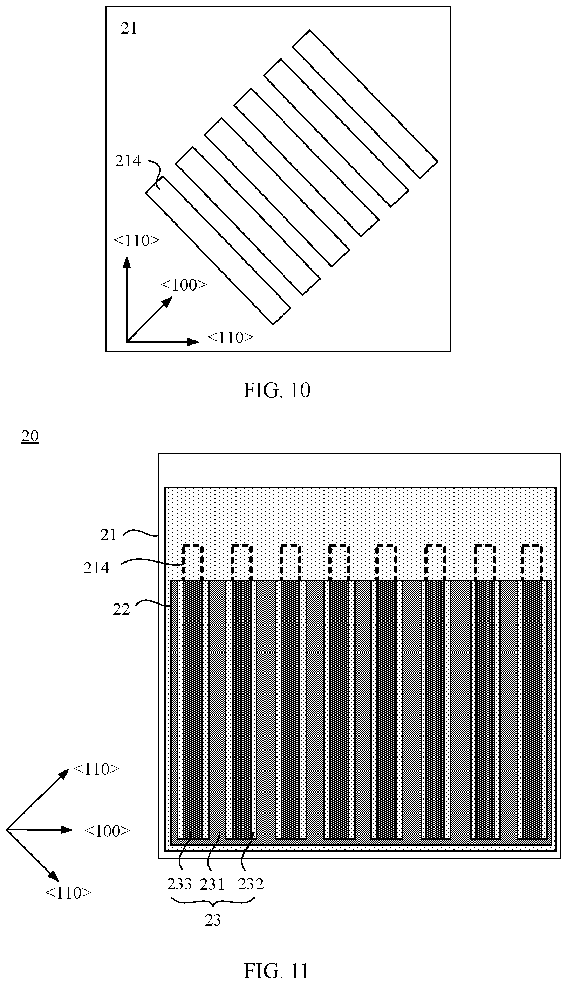

FIG. 10 is a diagram of an arrangement manner of cavities according to an embodiment of this application.

In view of this, in some embodiments, as shown in FIG. 10, the plurality of cavities 214 in the substrate 21 are sequentially arranged along a first direction of the substrate 21, and a value of the first direction deviates within a range of ±15° of a <100> crystal orientation of the substrate 21.

It should be understood that the value of the first direction may be within the foregoing range, but a value of the first direction in a same piezoelectric element is the same and fixed, and only one fixed value can be selected from the range. Values of the first direction in different piezoelectric elements may be different.

In this embodiment of this application, the substrate 21 may be a substrate that is of a (100) orientation and whose flat edge is in a <110> or <100> direction. Alternatively, the substrate 21 may be a substrate that is of a (110) orientation and whose flat edge is in a <110>, <100>, or <111> direction. This is not limited in embodiments of this application.

For example, the substrate 21 is of a (100) orientation, the flat edge of the substrate 21 is in a <110> direction, and the value of the first direction deviates within a range of ±15° of a <100> crystal orientation of the substrate 21. It indicates that the value of the first direction lies within the range of +15° deviating from the included angle of 45° between the substrate 21 and the flat edge. In other words, the value of the first direction is an orientation corresponding to the included angle of 30° to 60° between the substrate 21 and the flat edge.

Alternatively, for example, the substrate 21 is of a (100) orientation, the flat edge of the substrate 21 is in a <100> direction, and the value of the first direction deviates within a range of ±15° of a <100> crystal orientation of the substrate 21. It indicates that the value of the first direction lies within the range of ±15° deviating from the included angle of 90° between the substrate 21 and the flat edge. In other words, the value of the first direction is an orientation corresponding to the included angle of 75° to 105° between the substrate 21 and the flat edge.

Alternatively, for example, the substrate 21 is of a (110) orientation, the flat edge of the substrate 21 is in a <110> direction, and the value of the first direction deviates within the range of ±15° of the <100> crystal orientation of the substrate 21. It indicates that the first direction lies within the range of ±15° deviating from the included angle of 90° between the substrate 21 and the flat edge. In other words, the value of the first direction is an orientation corresponding to the included angle of 30° to 60° between the substrate 21 and the flat edge.

Alternatively, for example, the substrate 21 is of a (110) orientation, the flat edge of the substrate 21 is in a <100> direction, and the value of the first direction deviates within the range of ±15° of the <100> crystal orientation of the substrate 21. It indicates that the value of the first direction lies within the range of ±15° deviating from the included angle of 90° between the substrate 21 and the flat edge. In other words, the value of the first direction is an orientation corresponding to the included angle of 30° to 60° between the substrate 21 and the flat edge.

Alternatively, for example, the substrate 21 is of a (110) orientation, the flat edge of the substrate 21 is in a <111> direction, and the value of the first direction lies within the range of ±15° of the <100> crystal orientation of the substrate 21.

In some embodiments, as shown in FIG. 10, a cross section (or understood as a top view of the cavity 214) that is of the cavity 214 and that is parallel to the substrate 21 is a strip pattern, and the plurality of cavities 214 are arranged along a direction parallel to a short side of the strip pattern. In this case, a short side direction of the cavity 214 is parallel to the first direction.

A shape of the cross section of the cavity 214 is a strip shape. For example, the shape of the cross section of the cavity 214 is a rectangle with right angles, a chamfered rectangle, an ellipse, a rhombus, a triangle, a trapezoid, or an irregular strip shape.

The cross section of the cavity 214 is set to be a strip pattern, to balance a large displacement amount and a small gap while meeting requirements of the piezoelectric element 20. For example, when the piezoelectric element 20 is used in an inkjet printhead of a printer, a cavity 214 needs to be large enough to generate sufficient vibration displacement and pressure. Therefore, a large displacement amount is required. Each cavity 214 is connected to an inkjet nozzle on the outside, and a gap between inkjet nozzles needs to be small enough to meet an actual printing requirement. Therefore, a small gap is required.

It should be understood that the substrate 21 is a face-centered cubic lattice. Therefore, when the shape of the cross section of the cavity 214 is a rectangle, a long side direction of the cavity 214 is also parallel to the first direction. For example, the short side direction is a <100> crystal orientation, and an included angle between the short side direction and the flat edge is 45°. In this case, the long side direction is also a <100> crystal orientation, and an included angle between the long side direction and the flat edge is 45°.

In some embodiments, the first direction is a direction in which the value of $\frac{E}{1 - {ν}^{2}}$ of the vibration plate 22 is the smallest.

For example, the first direction is a <100> crystal orientation, and an included angle between the first direction and the flat edge is 45°.

FIG. 11 is a top view of a piezoelectric element according to an embodiment of this application.

As shown in FIG. 11, the piezoelectric element 20 includes the plurality of piezoelectric units 23 and the plurality of cavities 214. The plurality of cavities 214 are arranged along the first direction, and the plurality of piezoelectric units 23 are also arranged along the first direction. The projection of the piezoelectric unit 23 on the vibration plate 22 overlaps the projection of the cavities 214 on the vibration plate 22.

In the piezoelectric element 20 provided in embodiments of this application, an arrangement direction of the plurality of cavities 214 in the substrate 21 deviates within the range of ±15° of the <100> crystal orientation of the substrate 21. In the deviation range of ±15° of the <100> crystal orientation of the substrate 21, a value of $\frac{E}{1 - {ν}^{2}}$ of the vibration plate 22 is small, and the value of $\frac{E}{1 - {ν}^{2}}$ of the vibration plate 22 is the smallest in the <100> crystal orientation of the substrate 21. Therefore, after the plurality of cavities 214 are arranged along the foregoing direction, the thickness of the vibration plate 22 can be increased when a value of the bending stiffness *D* is fixed. After the thickness of the vibration plate 22 is increased, a variation of the thickness of the vibration plate 22 poses less impact on the overall thickness of the vibration plate 22 in a preparation process, to reduce impact of a film thickness deviation, a film quality deviation, and a mechanical performance deviation of the vibration plate on uniformity. This helps reduce a performance deviation and a performance variation of the piezoelectric element 20 that are caused by the film thickness deviation, the film quality deviation, and the mechanical performance deviation of the vibration plate 22 while implementing miniaturization and high density of the piezoelectric elements 20. This is applicable to the piezoelectric device 10 with a large displacement amount and a small displacement deviation. For example, in the piezoelectric element 20 shown in FIG. 2B, the variation of the thickness of the vibration plate 22 is usually about ±20%. However, in the piezoelectric element shown in FIG. 11, a variation of the thickness of the vibration plate 22 may be controlled within ±5% to ±10%, to significantly reduce the performance deviation and the performance variation of the piezoelectric element 20.

In addition, a crystallization direction of the vibration plate 22 formed by using the epitaxial process is determined by a direction of the substrate 21. Therefore, distribution of $\frac{E}{1 - {ν}^{2}}$ in different directions on the plane is different. The cavities 214 are arranged along a direction of lower $\frac{E}{1 - {ν}^{2}}$, to reduce the performance deviation and performance variation of the piezoelectric element 20.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A piezoelectric element, comprising:
a substrate, having a plurality of cavities that penetrate the substrate along a thickness direction, wherein the plurality of cavities are sequentially arranged along a first direction of the substrate, and the substrate is a monocrystalline silicon substrate;
a vibration plate, covering the substrate and the plurality of cavities; and
a plurality of piezoelectric units, wherein the piezoelectric unit comprises a first electrode, a piezoelectric layer, and a second electrode that are stacked on a side that is of the vibration plate and that is away from the substrate, and projection of the piezoelectric unit on the vibration plate overlaps projection of the cavity on the vibration plate, wherein
a value of the first direction deviates within a range of ±15° of a <100> crystal orientation of the substrate.

2. The piezoelectric element according to claim 1, wherein the first direction is a direction in which a value of E/(1-v²) of the vibration plate is the smallest, E is a Young's modulus of the vibration plate, and v is a Poisson's ratio of the vibration plate.

3. The piezoelectric element according to claim 1 or 2, wherein a cross section that is of the cavity and that is parallel to the substrate is a strip pattern, and the plurality of cavities are arranged along a direction parallel to a short side of the strip pattern.

4. The piezoelectric element according to any one of claims 1 to 3, wherein a thickness of the vibration plate ranges from 0.5 µm to 5 µm.

5. The piezoelectric element according to any one of claims 1 to 3, wherein the vibration plate is a film layer formed by a monocrystalline material.

6. The piezoelectric element according to any one of claims 1 to 5, wherein the monocrystalline material comprises a monocrystalline oxide.

7. The piezoelectric element according to any one of claims 1 to 6, wherein the substrate is of a (100) orientation, and a flat edge of the substrate is in a <110> or <100> direction.

8. The piezoelectric element according to any one of claims 1 to 7, wherein the substrate is of a (110) orientation, and the flat edge of the substrate is in a <110>, <100>, or <111> direction.

9. A piezoelectric device, comprising a drive circuit and the piezoelectric element according to any one of claims 1 to 8, wherein the drive circuit is electrically connected to the piezoelectric element.

10. An electronic device, comprising a housing and the piezoelectric device according to claim 9, wherein the piezoelectric device is disposed in the housing.

11. A preparation method for a piezoelectric element, comprising:
providing a substrate, wherein the substrate is a monocrystalline silicon substrate;
forming a vibration plate on one side of the substrate, wherein the vibration plate covers the substrate;
forming a plurality of piezoelectric units on a side that is of the vibration plate and that is away from the substrate, wherein projection of the piezoelectric unit on the vibration plate overlaps projection of the cavity on the vibration plate, and the piezoelectric unit comprises a first electrode, a piezoelectric layer, and a second electrode that are stacked on the side that is of the vibration plate and that is away from the substrate; and
forming, on the substrate, a plurality of cavities that penetrate the substrate, wherein the plurality of cavities are sequentially arranged along a first direction of the substrate, and a value of the first direction deviates within a range of ±15° of a <100> crystal orientation of the substrate.

12. The preparation method according to claim 11, wherein forming the vibration plate on the side of the substrate comprises:
forming the vibration plate on the side of the substrate by using an epitaxial growth process.

13. The preparation method according to claim 11 or 12, wherein a thickness of the vibration plate ranges from 0.5 µm to 5 µm.
